# EUROPEAN PATENT SPECIFICATION

(11) **EP 3 427 353 B1**
(45) Date of publication and mention of the grant of the patent: **02.06.2021**
(21) Application number: 17709637.7
(22) Date of filing: 07.03.2017
(51) Int. Cl.: H02B 1/052, H02B 1/04

(54) **RAIL FIXING SYSTEM WITH SYSTEM COUPLING**
SCHIENENBEFESTIGUNGSSYSTEM MIT SYSTEMKOPPLUNG
SYSTÈME DE FIXATION DE RAILS AVEC COUPLAGE DE SYSTÈMES

(30) Priority: 07.03.2016 DE 102016203700
(43) Date of publication of application: 16.01.2019
(73) Proprietor: TE Connectivity Germany GmbH, 64625 Bensheim (DE)
(72) Inventor: OFENLOCH, Markus, 68642 Bürstadt (DE); TUEY, Ufuk, 69309 Mannheim (DE); ZIMMER, Frank, 64283 Darmstadt (DE); HECK, Sandra, 64560 Riedstadt (DE)
(74) Representative: Grünecker Patent- und Rechtsanwälte PartG mbB
(86) International application number: PCT/EP2017/055258
(87) International publication number: WO 2017/153370

(56) References cited:
- EP-A1- 1 742 315
- DE-C1- 19 748 530
- US-A1- 2006 079 124

## Description

The invention relates to a rail fixing system for devices which can be fixed to a profile rail, in particular a top hat rail, having a rail fixing arrangement for fixing the rail fixing system to the profile rail, wherein the rail fixing arrangement has a first movable positive-locking connection element, having a system coupling arrangement for fixing to each other rail fixing systems which are arranged on the profile rail beside each other, wherein the system coupling arrangement has a second movable positive-locking connection element and wherein the rail fixing arrangement and the system coupling arrangement have a common movable actuation device which is connected to the first positive-locking connection element and second positive-locking connection element so as to transmit movement, wherein the actuation device is supported on at least one resilient element, wherein the first positive-locking connection element, the second positive-locking connection element and the resilient element are arranged along a straight line which extends in the effective direction of the resilient element. The actuation device also comprises at least a cam, as further defined in claim 1.

The invention further relates to a set comprising at least two rail fixing systems for devices which can be fixed to a profile rail, in particular a top hat rail.

Rail fixing systems are adequately known from the prior art. Thus, for example, DE 40 11 447 A1 sets out a rail fixing system for rapid fixing for an electrical installation device. The rapid fixing system set out is selectively brought into an open position or a closed position of a clamping element by means of an actuation element. DE 197 48 530 B9 further discloses a rail fixing system comprising the features of the preamble of claim 1.

Rail fixing systems of the prior art whose rail fixing arrangement and system coupling arrangement have a common actuation device generally have the disadvantage that the actuation device can become jammed or retention forces which are sufficiently great for the system coupling are not ensured.

The solutions of the prior art of the rail fixing systems relate only to a single rail fixing system, respectively.

When devices are fixed to a profile rail, in particular a top hat rail, it is desirable to ensure a reliable engagement of the rail fixing system with the profile rail. On the other hand, it is desirable to connect adjacent rail fixing systems or devices to each other mechanically and/or electrically.

That mechanical connection of adjacent rail fixing systems increases the resistance of the individual rail fixing systems to slippage on the profile rail because a single rail fixing system does not now have to apply this resistance but instead an assembly of rail fixing systems acts counter to a possible displacement.

This further has the additional advantage that the system coupling can also act as a fail-safe system for fixing the rail fixing system to the profile rail. If the fixing of a rail fixing system is defective or if it does not ensure an adequate clamping of the rail fixing system to the profile rail, or any clamping at all any longer, this sometimes leads in non-coupled rail fixing systems to the affected rail fixing system falling off the profile rail in an uncontrolled manner or to an uncontrolled displacement of the affected rail fixing system along the profile rail. In the case of coupled rail fixing systems, the assembly may prevent a single defective rail fixing system from falling off and/or being displaced in an uncontrolled manner.

An object of the invention is consequently to provide a rail fixing system which allows reliable fixing of the rail fixing system to the profile rail and a system coupling to adjacent rail fixing systems.

Another object of the present invention is to provide a rail fixing system which allows both the rail fixing system to be retained in a non-releasable manner on the profile rail and the displacement thereof on the profile rail at the same time.

Another object of the present invention is to provide a stable rail fixing system and system coupling with greater retention forces than the solutions of the prior art and to retain the rail fixing system in a robust manner without increasing the structural space thereof.

The rail fixing system according to the invention of the type mentioned in the introduction achieves these objects in that the actuation device has at least one rotatable cam and in that the position of the first positive-locking connection element and second positive-locking connection element is dependent on a rotational position of the at least one cam. Consequently, the present invention successfully makes provision for the rail fixing system and the system coupling to be placed in a mutually effective connection not only functionally but also for them to be combined in a compact form in spatial terms by the rail fixing system and the system coupling being arranged along the force path of the resilient element.

A rotatable cam has the advantage that it can provide both a force conversion and a conversion of the direction of the force applied by the user.

The set which is mentioned in the introduction and which comprises at least two rail fixing systems achieves the above objects in that at least one, preferably each, of the rail fixing systems is a system according to the invention.

These solutions have the advantage that a single element can be used to actuate two functions. Consequently, respective individually constructed actuation devices for the rail fixing system and for the system coupling are unnecessary. This further results in simplification of the rail fixing system, a simpler applicability and not least a cost saving during production.

As a result of the first positive-locking connection element, the second positive-locking connection element and the resilient element being arranged along the straight line which extends in the effective direction of the resilient element, a stable positive-locking connection of the mentioned positive-locking connection elements can be made possible as a result of the central arrangement of the positive-locking connection elements in the force path of the resilient element. Consequently, in comparison with solutions of the prior art, higher retention forces of the first or second positive-locking connection element are possible. The retention forces of the solutions of the prior art are generally limited not by the resilient force of the resilient element as a result of positive-locking connection elements which are arranged outside the force path, but instead by the actuation device tilting as a result of the decentralised arrangement described above.

Another advantage of the rail fixing system according to the invention is a compact and space-saving construction thereof.

The system coupling of a plurality of rail fixing systems with each other has the advantage of an additional securing of the fixing of the rail fixing system on the profile rail because the system coupling of two or more adjacent rail fixing systems also ensures additional fixing of the position of a rail fixing system located in the set when the rail fixing arrangement thereof cannot ensure the reliable fixing of the rail fixing system on the profile rail completely any longer or at all.

Furthermore, in the case of a complete engagement of a plurality of rail fixing systems with each other, a defined connection is ensured, for example, via a receiving depth or insertion depth of the second positive-locking connection element.

The solutions according to the invention may be freely combined with the following embodiments, which are advantageous per se, and further improved.

In a first advantageous embodiment of the rail fixing system according to the invention, the rail fixing system has a channel-like rail receiving member which is continuous in a passage direction for the profile rail, wherein the actuation device can be displaced transversely relative to the passage direction and wherein the straight line which extends in the effective direction of the resilient element extends through the channel-like rail receiving member. Such a movement of the actuation device has the advantage that a possible movement of the rail fixing system along the profile rail can be blocked in both directions along the profile rail to the same extent.

The straight line which extends in the effective direction of the resilient element is intended to be understood to be a virtual auxiliary construct. In this case, the straight line is a line comprising the large number of possible lines which extend in or counter to the effective direction of the resilient element.

The expression that an element is arranged along the straight line is intended to be understood to mean that the straight line passes substantially centrally through the element. The arrangement of the resilient element along the straight line which extends in the effective direction of the resilient element can consequently be understood in the case of a helical spring being used in such a manner that the straight line extends centrally through the cylindrical inner space which is formed by the turns of the helical spring.

The term "rail receiving member" is intended to be understood to be the free space which is inside the cubature of the rail fixing system and in which a profile rail can be inserted. The rail receiving member is preferably substantially complementary to the profile rail used. Preferably, a top hat rail and, more preferably, a DIN top hat rail may be used.

The straight line may preferably extend through the channel-like rail receiving member transversely relative to the passage direction.

The rail receiving member may have a rigid clamping element at one side of the rail receiving member in the actuation direction, wherein the clamping element mentioned may be constructed as a catch hook which engages under the top hat rail.
The movable first positive-locking connection element can be arranged at the opposite side of the rail receiving member and, depending on the movement or position of the first positive-locking connection element, it can project further into the rail receiving member in some positions than in other positions.

A border of the rail receiving member may comprise both walls of a housing of the rail receiving member and the first positive-locking connection element which can be moved into the rail receiving member. Since this element is movable, the shape and size of the rail receiving member may be dependent on the position of the actuation device.

As known from the prior art, the rail fixing system according to the invention may also configure the actuation device in such a manner that it can be engaged in an open position for fitting to the profile rail and in a closed position for simultaneous fixing to the profile rail and an adjacent rail fixing system.

Engagement in the open position has the advantage that a user does not necessarily have to ensure, during installation of a device with the rail fixing system according to the invention, that he has to manually hold open this open position. Furthermore, clearly defined engagement positions have the advantage that, although the rail fixing system can be located in all positions between the open position and the closed position, the positions relevant for the user can be clearly predetermined and communicated to the user with corresponding feedback.

Furthermore, such an engagement affords a given feedback about the compatibility of the rail fixing system with the profile rail as well as feedback about a possible defect of the profile rail and/or the rail fixing system used.

If a device with the rail fixing system according to the invention which is located in the open position, for example, does not fit a profile rail, this is an indication for the user that either the rail fixing system used may be configured for a different dimension of the profile rail present, or that there may be a possible error or defects of the rail fixing system or the profile rail.

The movement of the movable actuation device can be ensured by a drive element, wherein the actuation device can be supported by means of a resilient element against the drive element. The resilient element and the drive element may be located at opposite sides of the rail receiving member in the actuation direction.

The engagement of the actuation device can be produced directly by an engagement element which is provided thereon or preferably indirectly by means of a blockage of the further movement of the drive element.

In a third advantageous embodiment of the rail fixing system according to the invention, the actuation device is constructed between the open position and the closed position so as to be able to be engaged in a displacement position for displacement of the rail fixing system along the profile rail. An engagement of the actuation device in the displacement position has the advantage that the actuation device does not have to be retained therein while a displacement of the rail fixing system is carried out along the profile rail.

In the displacement position, although the rail fixing system is connected to the profile rail in a non-releasable manner, the connection does not prevent the displacement along the profile rail.

A play may be present between the rail receiving member and the profile rail and allows displacement.

In the open position, the first positive-locking connection element is advantageously moved out of the rail receiving member and, in the closed position, moved into the rail receiving member under resilient force. This has the advantage that the first positive-locking connection element which is moved out of the rail receiving member releases the path for a profile rail into the rail receiving member and the movement of the first positive-locking connection element into the rail receiving member under resilient force further has the advantage that the first positive-locking connection element is pressed against the profile rail under the resilient force mentioned.

The first positive-locking connection element may be a clamping element, it may preferably be constructed as clamping jaws. The first positive-locking connection element can be moved in the open position completely out of the rail receiving member or still project only partially into the rail receiving member.

The first positive-locking connection element can in particular be moved in the open position out of the rail receiving member to such an extent that the positioning of the rail fixing system on the profile rail can be carried out in such a manner that a parallel arrangement of the rail fixing system with respect to the profile rail can be maintained in the process of the positioning and only a movement of the complete rail fixing system is brought about in the direction in which the first positive-locking connection element was moved out of the rail receiving member.

In such an embodiment, the side of the rail receiving member which accommodates the first positive-locking connection element may have an inclined introduction member which can be provided in such a manner that, during a measurement of the clear width parallel with the actuation direction from the inclined introduction member to the opposite side of the rail receiving member where a rigid non-movable clamping jaw may be located, the clear width is always greater than the width of the profile rail intended to be received.

Consequently, it is possible to prevent the rail fixing system from being positioned on the profile rail by being rotated inwards. This is advantageous, for example, when such inward rotation is impossible for reasons of the present receiving geometry for the rail fixing systems or devices which have such a rail fixing system.

In another advantageous embodiment of the rail fixing system according to the invention, the first positive-locking connection element in the displacement position projects in or counter to the effective direction of the resilient element into the rail receiving member to a lesser extent than in the closed position. The less extensive projection into the rail receiving member has the advantage that the rail fixing system is already fixed to the profile rail and is non-releasable, but still allows a movement of the rail fixing system along the profile rail.

Since, as described above, the first positive-locking connection element can be constructed as a set of clamping jaws, those clamping jaws can engage behind an inserted profile rail or portions of the inserted profile rail in such a manner that a freedom of movement of the rail receiving system on the profile rail remains in all spatial directions.

The clamping jaws may be constructed so as to be substantially triangular or conical, wherein a preferably rounded tip of the triangle or the conically formed clamping jaws can protrude further into the rail receiving member than a base of the triangle or the conically formed clamping jaws.

Furthermore, the triangular or conically formed clamping jaws can be constructed asymmetrically, that is to say that a side wall which extends from the tip of the clamping jaws can extend in the direction counter to the opening of the rail receiving member at a different angle with respect to a side wall which extends from the tip in the direction of the opening of the rail receiving member.

Consequently, the tip of the clamping element which is formed in a triangular or conical manner may not project in a vertical extent centrally into the rail receiving member but may instead be constructed so as to be offset in the direction of the opening of the rail receiving member and movable into the rail receiving member. In this case, the vertical extent corresponds to an extent of the rail receiving member in a vertical direction which is orientated perpendicularly to the actuation direction and perpendicularly to the passage direction.

If the actuation device and the first positive-locking connection element connected thereto are located in the displacement position, the rail receiving member may have a clear width, measured in the actuation direction and parallel with the actuation device at the height of the tip of the triangular or conical clamping element, which is smaller than the width of the profile rail which is intended to be received or which is received.

In a region of the rail receiving member which is further away from the opening of the rail receiving member, the rail receiving member may have a clear width which may further be greater than the width of the profile rail which is intended to be received or which is received.

Specifically, the clear width measured in the upper region can be dimensioned so that the profile rail in this region abuts the inner walls or inwardly projecting elements of the rail receiving member with a play but, as a result of this abutment, apart from the weight forces which cannot be avoided, no additional forces at all, for example, as a result of resilient elements, are transmitted from the rail fixing system to the profile rail.

In another advantageous embodiment of the rail fixing system according to the invention, the actuation device is substantially completely received inside the rail fixing system. This has the advantage that an unintentional mechanical actuation or influence of the actuation device is prevented. The actuation device can be completely enclosed by a housing of the rail fixing system, that is to say, housed, and, for example, only be accessible in the region of the first and second positive-locking connection element from outside the housing. The actuation device may be able to be actuated in particular indirectly so that undesirable actuation thereof from outside the housing is unnecessary.

The second positive-locking connection element can preferably extend in all embodiments of the rail fixing system according to the invention substantially perpendicularly to the actuation direction and substantially parallel with the passage direction.

The second positive-locking connection element can be arranged so as to be accessible from outside the rail fixing system at a lateral face of the rail fixing system, which face extends transversely relative to the passage direction.

The second positive-locking connection element can be constructed as a catch opening or catch hook. If the second positive-locking connection element is constructed as a catch hook, it may have a stop face which can be constructed parallel with the lateral face of the rail fixing system and so as to be directed towards it.

If the second positive-locking connection element is constructed as a catch opening, this catch opening may be an opening extending through the actuation device or constitute a recess in the actuation device.

The catch opening may preferably extend in the actuation direction and may have lateral walls which are directed in or counter to the actuation direction and which can be constructed differently in or counter to the passage direction.

Thus, for example, it is possible for a lateral wall of the catch opening to have an inclined introduction member in a manner accessible from outside the rail fixing system, whereas the lateral wall of the catch opening located at the opposite side of the inclined introduction member in the passage direction there may be provided a stop face which extends parallel with the actuation direction. The inclined introduction member may also be constructed in the form of a rounded portion which can be very readily constructed, for example, by injection moulding.

In another embodiment of the rail fixing system according to the invention, the second positive-locking connection element is constructed as a positive-locking connection opening which opens substantially perpendicularly to the straight line and which is completely surrounded with a closed peripheral wall.

Such a positive-locking connection opening has the advantage that the second positive-locking connection element which is constructed as the positive-locking connection opening is received completely inside the housing of the rail fixing system and no movable portions of the actuation device project out of the housing.

A peripheral wall has the advantage that it, for example, is more stable than a free-standing lug or projection and consequently allows greater retention forces. If the second positive-locking connection element is in positive-locking connection, a possible introduction of forces can be carried out into the actuation device in an extensive manner and not, as in a free-standing lug, only via a single contact point or line.

In another advantageous embodiment of the rail fixing system according to the invention, the positive-locking connection opening is encoded by a contour of the wall.

The contour of the wall may be of any size and/or form. Different contours have the common feature that they each receive only corresponding positive-locking connection counter-elements which are provided with a counter-contour and block positive-locking connection counter-elements which do not correspond.

In order to encode device variants, the second positive-locking connection element can be constructed with different numbers and/or forms and/or at different positions of the rail fixing system. Thus, in an exemplary first variant of the rail fixing system according to the invention, the second positive-locking connection element can be constructed as a catch opening which opens in the passage direction and, in an exemplary second variant, as a catch opening which opens counter to the passage direction. Furthermore, the catch openings which open in different directions in respect of the two exemplary variants can be arranged at different positions in the rail fixing system.

The actuation device can be constructed in a monolithic manner and can form the first and second positive-locking connection element. A monolithic construction of the actuation device affords the advantage of a simple and cost-effective production of the actuation device and furthermore a reduction of the time required to assemble or introduce the actuation device in the rail fixing system.

Such a monolithic construction can further advantageously be brought about by means of conventional injection-moulding techniques.

In another advantageous embodiment of the rail fixing system according to the invention, the actuation device is supported at the centre thereof in a direction perpendicular to the passage direction. This has the advantage that bending of the actuation device perpendicularly to the passage direction is prevented or minimised.

Since the actuation device can be pretensioned by a resilient element and this resilient element can be located in the actuation direction at the opposite side of the rail receiving member in relation to a drive element, there is the risk that the actuation device may flex at the centre thereof.

In order to counteract this flexion, the actuation device can be supported at the centre thereof in a guide receiving member of the rail fixing system in such a manner that it is possible to move the actuation device in the actuation direction or counter to the actuation direction but the guide receiving member is constructed so as to correspond to the actuation device with little play.

The term "little play" is intended to be understood in this instance to mean that the play between the actuation device and the guide receiving member is smaller than the extent or thickness of the actuation device at the centre thereof. Preferably, this play between the actuation device and the guide receiving member may be smaller than half the extent or thickness of the actuation device in the central region, more preferably smaller than one tenth of the extent of the actuation device in the central region.

The actuation device may have in the central region at least one wing-like wall which is orientated in or counter to the passage direction and parallel with the actuation direction and which projects from the actuation device. That wall can be constructed in different forms, such as, for example, in a rectangular manner.

Such a wall can be guided, for example, in a slot-like guide receiving member which extends parallel with the actuation direction. In the event of a possible flexion of the actuation device, the wall would abut the inner side of the slot-like guide receiving member in or counter to the vertical direction and would consequently prevent further flexion of the actuation device.

The flexion of the actuation device can be prevented or minimised in or counter to the vertical direction, in or counter to the passage direction or in or counter to both directions by means of a guide receiving member described above.

In another embodiment of the rail fixing system according to the invention, it is advantageous for a counter-element which is encoded so as to complement the second positive-locking connection element to be located at one of the two lateral faces opposite each other in a passage direction. This arrangement has the advantage that the system coupling of two or more rail fixing systems can be standardised and a preferred orientation of the rail fixing system can further be predetermined in relation to additional rail fixing systems.

The above-mentioned positive-locking connection counter-element may be such a counter-element. The term "complementary encoding" is intended to be understood to mean that the counter-element can be received in the second positive-locking connection element or the second positive-locking connection element can be received in the counter-element.

The complementary counter-element may preferably be rigid, that is to say, may be non-movable in relation to the rail fixing system. If the second positive-locking connection element is constructed as a catch hook, the complementary counter-element may be a rigid catch opening. If, however, the second positive-locking connection element is a catch opening, the complementary counter-element may be a catch hook which is fitted in a rigid, that is to say, non-movable, manner to the rail fixing system.

The second positive-locking connection element and the complementary counter-element may preferably have the same coordination in the vertical direction and in the actuation direction, wherein the position of both elements can differ only in terms of the coordinate thereof with respect to the passage direction. The opening direction of the catch opening may preferably be parallel with the extent direction of the catch hook.

In another advantageous embodiment of the rail fixing system according to the invention, a coupling control contour which has at least one protrusion or recess extending in the passage direction is constructed at one of the two lateral faces which are opposite each other in the passage direction.

Such a coupling control contour can be understood to be a second step of an encoding. In the case of the above-described encoding by means of the contour of the second positive-locking connection element and the counter-element, it may be the case that, for example, although a counter-element with a smaller size than the positive-locking connection opening but with a form which is different therefrom can be received in the positive-locking connection opening, a final coupling of both components associated with different systems is not desirable.

The achievement of a final coupling position between adjacent components can preferably be made possible only if a suitable coupling control contour-contour is received in the coupling control contour and is not blocked thereby.

The coupling control contour may preferably have a plurality of projections or recesses which project/are recessed in or counter to the passage direction. The size and/or form and/or arrangement of these projections or recesses may allow a large number of possible encodings so that the achievement of a final coupling position is possible only if the encoding of the coupling control contour corresponds to the encoding of the coupling control counter-contour. If this is the case, the projections are each received in the corresponding complementary recesses.

The projections may have a different height, measured in or counter to the passage direction away from the lateral wall, and a different spacing from each other.

The recesses can also have mutually different depths and a different spacing from each other.

The rotational position of the at least one cam can be limited to a specific angular range and, purely by way of example, this may be 180°. It is also possible for the at least one cam to be able to be brought into any desired rotational position, that is to say that the rotation thereof can be carried out in one of the two possible rotational directions about the axle of the cam at any desired angle, that is to say, also beyond 360°.

The at least one rotatable cam can be fitted to a shaft which extends in the vertical direction, that is to say, substantially perpendicularly to the actuation direction and substantially perpendicularly to the passage direction.

As a result of the limited structural space, for example, it may be possible for a rail fixing system to be able to be positioned from above the profile rail thereon but for the rail fixing system not to be able to be accessed from one of the two sides of the profile rail as a result of the small structural space.

Consequently, only access from above the profile rail may be possible with respect to the rail fixing system. If a plurality of rail fixing systems or devices having the rail fixing systems are installed on the profile rail, it is further also impossible to gain access from a lateral face of the rail fixing systems directed in or counter to the passage direction.

The actuation of the at least one cam can be carried out, for example, from above the profile rail or the rail fixing system by means of a shaft which receives the cam. If the cam is rotated indirectly or directly, an abutment face of the actuation device is spaced apart from the axle of the cam to a different extent as a result of the eccentricity of the cam in accordance with the rotational position of the at least one cam.

As a result of the eccentricity of the at least one cam, a maximum movement of the actuation device in the actuation direction can be determined. The actuation device can have one or more abutment faces which abut the one or more cams so as to transmit movement.

The at least one cam can have an element for indirectly or directly transmitting a torque. A direct transmission of a torque can be carried out, for example, by means of a groove which is orientated perpendicularly to the cam shaft and in which, for example, a screwdriver for transmitting a torque to the cam can be received.
A possible indirect transmission of a torque by means of a threaded arrangement is also conceivable. It is also conceivable for the transmission of a torque not to be brought about manually by a user but instead electrically, for example, by an electric motor or by a mechanically pretensioned resilient element.

In the last embodiment, the user can actuate the pretensioned resilient element by means of a trigger element so that the pretensioned resilient element can transmit a torque to the at least one cam and can consequently displace the actuation device in the actuation direction.

The actuation device can have a plurality of cams, as already mentioned, wherein the cams when viewed in the actuation direction can each be arranged at one side of the rail receiving member or at opposite sides of the rail receiving member. If the at least two cams are arranged opposite each other, one cam can be responsible for the movement of the actuation device in the actuation direction and the opposite cam for the opposing movement.

It is also conceivable, for example, to drive the at least one cam by means of a worm gear. A worm gear allows the user to transmit a torque to the cam which would not be able to be applied by the user in a direct manner, that is to say, directly to the axle of the cam.

The at least one cam can in particular be constructed in such a manner that only half a rotation of the cam is possible. An additional rotation of the cam can be prevented by means of at least one, preferably two, stop element(s). Such a limitation has the advantage that the rotational position of the at least one cam is in relation to the position of the actuation device in a bi-unique manner and not simply unambiguously.

In this subsequent disclosure, the term "actuation element" is used synonymously with the term "actuation device". Both actuation device and actuation element relate to the same technical feature.

The engagement of the actuation element can be enabled by means of a catch element which can be constructed at or on the stop face of the actuation element and a catch counter-element which can be constructed on the peripheral face of the at least one cam.

The catch element at or on the stop face of the actuation element can be constructed as a catch hook, catch recess or catch projection. The counter-element on the peripheral face of the at least one cam can be complementary, that is to say, can be constructed as a catch projection for the first two embodiments of the catch element of the stop face or as a catch recess for the third embodiment above of the catch element of the stop face.

It is also possible for the counter-element to be constructed as a catch edge but this is less advantageous from a construction point of view and requires correct orientation during installation of the cam in the rail fixing system. However, a cam with a catch recess or catch projection can be readily received in the rail fixing system during assembly of the rail fixing system in a state rotated through 180° about a direction parallel with the actuation direction.

The catch element of the stop face of the actuation element and the catch counter-element of the at least one cam can define the open position, the displacement position and the closed position of the actuation element.

In these three positions or in a plurality of positions, the engagement between the catch element and the catch counter-element can be self-blocking. This means that the resilient element presses the actuation element with the stop face against the surface of the at least one cam in such a manner that additional rotation of the at least one cam in the direction of a rotational position which corresponds to the closed position can be carried out only when the actuation element is redirected counter to the resilient action of the resilient element so that the catch element can be brought out of engagement with the catch counter-element.

The mechanical contact between the stop face of the actuation element and the peripheral face of the at least one cam can be constructed in such a manner that, when the engagement is released, the effect of the force of the resilient element is sufficient to move the at least one cam from a rotational position corresponding to the open position into a rotational position corresponding to the displacement position or from the rotational position corresponding to the displacement position into a rotational position corresponding to the closed position.

In order to cancel the engagement of the catch element of the stop face with the catch counter-element of the cam, it may be necessary for the user to act on the at least one cam with a torque so that the actuation element is redirected by means of the catch counter-element counter to the resilient action in the actuation direction and consequently the catch element is brought out of engagement with the catch counter-element.

The torque which is intended to be applied can be used as haptic feedback for the user while an additional rotation of the at least one cam may be possible without any significant expenditure of force by the user.

In another advantageous embodiment of the rail fixing system according to the invention, there is provided a display element which is connected to the actuation device and which is movable therewith for displaying the position of the actuation device in a manner visible from outside the rail fixing system. Such a display element provides the user with immediate information about the position of the actuation device, that is to say, for example, whether the rail fixing system is in the open position and can consequently be positioned on a profile rail immediately.

The display element may be an edge which is provided at a distal end of the actuation device with respect to the rail receiving member and which is also in accordance with the position of the actuation element moved therewith and which projects via a rigid element, that is to say, a non-movable element, of the rail fixing system or is covered thereby.

Furthermore, the display element can also be visible simply by means of a viewing opening in a rigid, that is to say, non-movable, portion of the rail fixing system. In such a case, the display element may be able to be seen completely in the viewing opening, for example, in one of the three above-described positions or in additional positions of the actuation element, while only half of it may be visible in the viewing opening in a second position of the actuation element and it may not be visible at all in the viewing opening in the third position.

The display element can be provided at any side of the actuation element or at both sides of the actuation element. Specifically the embodiment at both sides of the actuation element has the advantage that at least one display element fitted at one side can continue to be visible if the opposite display element is covered, for example, as a result of small structural space.

In another advantageous embodiment of the rail fixing system according to the invention, the display element is constructed monolithically with the actuation device. This has the advantage that the production of the actuation device which is provided with the display element can be simplified, costs therefor can be reduced and the assembly or installation in the rail fixing system can also be simplified.

As already described above, a part-portion of the actuation element per se can be constructed as a display element. Furthermore, it is also possible for the display element to project from the actuation element in order to produce the display of the position of the actuation element at a predetermined position in the rail fixing system.

In another advantageous embodiment of the rail fixing system according to the invention, the first positive-locking connection element is located at the side of the channel-like rail receiving member opposite the cam. This has the advantage that the positioning of the rail fixing system on the profile rail can also be carried out when the structural space at one side of the profile rail does not allow a position of the rail fixing system or of a device which comprises a rail fixing system projecting further beyond the profile rail than is the case in the closed position.

As already described above, the positioning of the rail fixing system on the profile rail can be carried out without the rail fixing system having to be rotated. That is to say that the actuation element is always orientated at the same angle with respect to the profile rail while the rail fixing system is positioned on the profile rail. The positioning on the profile rail is connected, in addition to a reduction of the spacing between the profile rail and the rail fixing system, with a movement of the complete rail fixing system in the direction of the first positive-locking connection element which has been moved out of the rail receiving member.

Before the start of the positioning process of the rail fixing system on the profile rail, however, it is necessary for the rail fixing system to be positioned laterally beyond the profile rail in relation to the position thereof in the positioned state counter to the direction in which the first positive-locking connection element has been moved out of the rail receiving member.

During positioning, the rail fixing system moves towards the profile rail and at the same time with superimposition of the movement directions in the direction in which the first positive-locking connection element was moved out of the rail receiving member.

If the distance by which the rail fixing system was moved beyond the profile rail in or counter to the actuation direction before the positioning process in relation to the position thereof in the positioned state is referred to as the insertion distance, there are sometimes systems for receiving the rail fixing systems according to the invention which do not allow the necessary insertion distance.

A rail fixing system which forms the first positive-locking connection element at the same side of the channel-like rail receiving member as the at least one cam would consequently have to be moved over the profile rail, before the positioning on the profile rail, in the direction from the cam to the profile receiving member beyond the position of the rail fixing system in the positioned state in order to ensure the movement of the rail fixing system counter to the direction from the cam towards the rail receiving member during the positioning process.

If, for example, a wall is located at the side of the profile rail opposite the cam, however, it may not be possible for the necessary insertion distance to be able to be ensured. In such a case, positioning of the first positive-locking connection element at the side of the channel-like rail receiving member opposite the cam allows positioning of the rail fixing system on the profile rail without the rail fixing system having to be moved beyond the profile rail in the direction of the side of the channel-like rail receiving member opposite the cam.

The set which is mentioned in the introduction and which comprises at least two rail fixing systems relates to a system having at least two rail fixing systems involved, wherein the effective connection thereof is preferably described in the state positioned on the profile rail, respectively. The designations first or second are selected purely by way of example and can naturally be exchanged. The system comprising at least two rail fixing systems is described below with reference to a purely exemplary profile rail which is described as extending from left to right in order to simplify the explanation. The designation left and right relate below to this exemplary system and are not intended to limit the scope of the invention.

The set may comprise a rail fixing system which has only one rail fixing arrangement, that is to say that this rail fixing system does not have a second positive-locking connection element which is connected to the actuation element. That rail fixing system is now intended to be referred to below as the first rail fixing system, wherein the designation is made purely by way of example. If the first rail fixing system is positioned on the profile rail, a rigid, non-movable counter-element of this first rail fixing system can be accessible to the left or to the right.

For the subsequent description, it is assumed that the counter-element is constructed as a catch hook and is directed to the right. This assumption is purely exemplary and is not limiting.

The second rail fixing system which can be constructed as a rail fixing system according to the present invention is now in this example positioned on the profile rail on the right beside the rail fixing system which has already been positioned on the profile rail. In this instance, the actuation elements of both rail fixing systems can be in the open position.

The second positive-locking connection element of the second rail fixing system is constructed in this explanation as a catch opening and is directed to the left. The two rail fixing systems can now be moved towards each other so that the rigid non-movable catch hook of the first rail fixing system can be received in the catch opening of the second rail fixing system.

After the catch hook has been completely received in the catch opening, the respective actuation element of both rail fixing systems can be actuated by means of a drive element so that the respective first positive-locking connection elements of the two rail fixing systems can be brought into positive-locking engagement with the profile rail and furthermore the second positive-locking connection element of the second rail fixing system can be brought into positive-locking engagement with the counter-element of the first rail fixing system.

The fixing of the rail fixing systems to the profile rail by means of the respective first positive-locking connection elements, in particular a retention force in the displacement direction on the profile rail, can be based substantially on frictional engagement in another embodiment of the rail fixing system according to the invention.

Both actuation elements can be engaged in the displacement position so that, although the system comprising the two rail fixing systems which are involved by way of example is connected by means of the positive-locking engagement between the second positive-locking connection element of the second rail fixing system and the counter-element of the first rail fixing system, the complete system can continue to be displaced along the profile rail.

Since the counter-element of the first rail fixing system is independent of the actuation element, the actuation element of the first rail fixing system may also be in the displacement or closed position before connection to the second rail fixing system. If it is in the closed position, this has the advantage that the second rail fixing system, for example, can be pushed towards the first rail fixing system with one hand without the first rail fixing system having to be held.

Subsequently, additional rail fixing systems according to the invention can now be positioned on the profile rail on the right beside the second rail fixing system, can be pushed from the right towards the second rail fixing system and can be engaged therewith by means of actuation of the actuation element of the rail fixing system which is intended to be connected. An engagement of the last-connected rail fixing system with the profile rail is also associated with the engagement with the left-hand rail fixing system, respectively.

It may further be advantageous for the positive-locking engagement between the second positive-locking connection element and the counter-element also to be able to be produced if the rail fixing system which is involved in the engagement with the second positive-locking connection element is in the displacement position and/or closed position.

By way of example, the above-described profile rail will continue to be taken as a basis and a rail fixing system according to the invention whose actuation element is in the displacement position is positioned thereon.

A second rail fixing system according to the invention is positioned on the profile rail on the right beside the first rail fixing system. The actuation element thereof is also in the displacement position. Both rail fixing systems can now be moved towards each other.

Purely by way of example, the first left-hand rail fixing system may have a catch opening which opens to the right as a second positive-locking connection element. The second rail fixing system has purely by way of example a catch hook which is directed to the left as a counter-element.

The catch hook can be provided with an inclined introduction member which abuts a catch wall of the catch opening and by means of which the actuation element of the first rail fixing system, which element is connected to the catch opening, can be redirected counter to the force effect of a resilient element.

It is also conceivable for this redirection to be possible if the first rail fixing system is in the fixed state, that is to say, if the actuation element is in the closed position.

The rail fixing system according to the invention may have two rail fixing arrangements, wherein, if the above exemplary non-limiting profile rail is retained, one rail fixing arrangement can be arranged on the left in the rail fixing system and another rail fixing arrangement can be arranged on the right in the rail fixing system.

Both rail fixing arrangements may be in different positions of the respective actuation element independently of each other. That is to say that the left rail fixing arrangement may be in the closed position while the right rail fixing arrangement is in the open position.

This may facilitate the reception of a counter-element of another rail fixing system since the right actuation element of the first rail fixing system can be prevented from having to be redirected counter to the resilient effect of the resilient element.

The resilient element can in particular further also be used as a tolerance compensation member for the top hat rail and can re-adjust the actuation element in the region of the clamping element in the event of incorrect use, such as, for example, abrasion.

The invention is explained below by way of example with reference to the drawings and embodiments. In this instance, the different features can be combined independently of each other, as already set out in the above individual advantageous embodiments. Technical features which have the same designation or function are indicated with the same reference numeral.

In the drawings:
- Fig. 1a: is a perspective view of a first embodiment of the actuation element according to the invention with a cam;
- Fig. 1b: is a perspective view of a second embodiment of the actuation element according to the invention with a resilient element inserted;
- Fig. 2a: is a side view of the rail fixing system according to the invention on a profile rail;
- Fig. 2b: shows a detail of a plan view of the rail fixing system from Fig. 2a in the open position;
- Fig. 2c: is a section of the plan view from Fig. 2b;
- Fig. 3a: is a side view of the rail fixing system according to the invention on a profile rail in the displacement position;
- Fig. 3b: shows a detail of a plan view of the rail fixing system from Fig. 3a in the displacement position;
- Fig. 3c: is a section of the plan view from Fig. 3b;
- Fig. 4a: is a side view of the rail fixing system according to the invention on a profile rail in the closed position;
- Fig. 4b: shows a detail of a plan view of the rail fixing system from Fig. 4a in the closed position;
- Fig. 4c: is a section of the plan view from Fig. 4b;
- Fig. 5a: shows a set of rail fixing systems before the system coupling;
- Fig. 5b: shows a set of rail fixing systems during the system coupling;
- Fig. 5c: shows a set of rail fixing systems after the system coupling; and
- Fig. 6: shows a counter-element with a coupling control counter-contour.

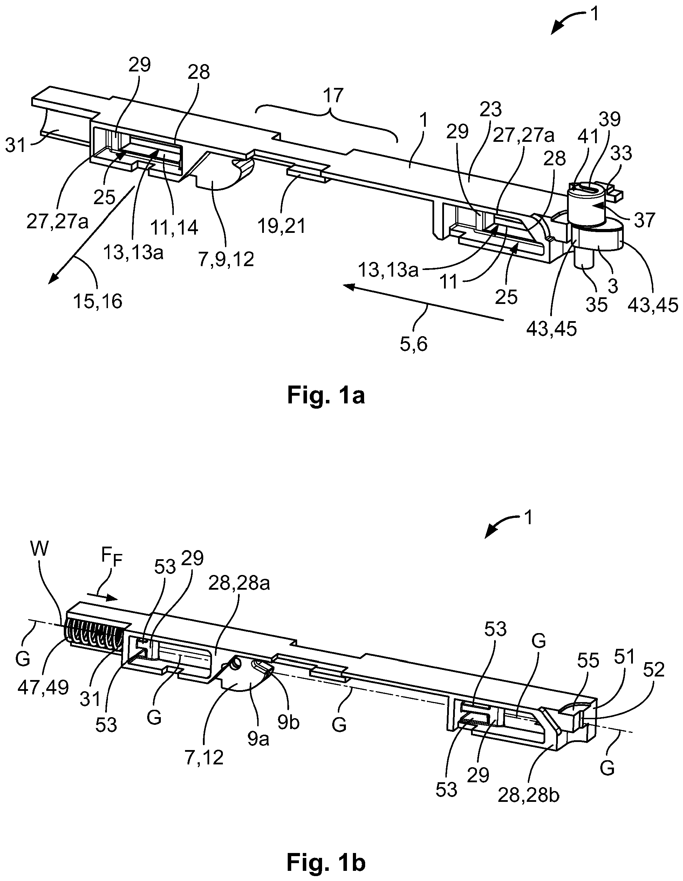

Figure 1 shows a first embodiment of an actuation element 1 with a cam 3. The actuation element 1 extends substantially in a longitudinal direction 5 and in the embodiment shown comprises a first positive-locking connection element 7 which is constructed as a clamping jaw 9 and two second positive-locking connection elements 11 which are constructed as catch openings 13 or as positive-locking connection openings 13a.

Since, as previously mentioned, the terms actuation device and actuation element can be used synonymously in this disclosure and can be freely exchanged for each other, both the actuation element and an actuation device are designated 1.

The longitudinal direction 5 corresponds to an actuation direction 6.

The first positive-locking connection element 7 is a component of a rail fixing arrangement 12 and the second positive-locking connection element 11 is a component of a system coupling arrangement 14.

The first positive-locking connection element 7 extends substantially counter to the longitudinal direction 5, the catch openings 13 or the positive-locking connection openings 13a open in or counter to a transverse direction 15 which corresponds to a passage direction 16.

In the central region 17, the actuation element 1 has a support element 19 which is constructed as wing-like struts 21 which extend at both sides, that is to say, extend both in and counter to the transverse direction 15. The wing-like struts 21 are arranged parallel with an upper side 23 of the actuation element 1.

The second positive-locking connection elements 11 are substantially constructed as a shaft 25 which extends in a transverse direction 15, wherein the shaft walls 27 partially constitute the upper side 23 of the actuation element and each surround a catch wall 29. The catch walls 29 will be discussed in greater detail in the subsequent Figures.

In this instance, the shaft walls 27 constitute a wall 27a of the positive-locking connection opening 13a. That wall 27a surrounds the positive-locking connection opening 13a, wherein the access locations thereto open in or counter to the transverse direction 15. The walls 27a have a contour 28. In Figure 1a, a first contour 28a is rectangular whereas a second contour 28b is in the form of a parallelogram.

The catch openings 13 extend substantially in the longitudinal direction 5. A resilient element receiving member 31 also extends in the longitudinal direction 5.

Furthermore, the actuation element 1 has a display element 33 which is directed to the right in the shown embodiment of the actuation element 1 but in other embodiments can also be fitted to the actuation element 1 at the opposite side in the longitudinal direction 5.

In the shown embodiment of the actuation element 1, it is monolithically connected to the resilient element receiving member 31, the second positive-locking connection elements 11, the first positive-locking connection element, the support element 19 and the display element 33.

The cam 3 is fixed to an axle 35 and has a drive element 37 which is constructed as a groove-like receiving member 39, for example, in order to receive the tip of a screwdriver (not shown). The drive element 37 further comprises an indicator element 41 which is constructed as an arrow-head.

The cam comprises three catch elements 43 which are constructed as a catch projection 45 and of which only two can be seen in Figure 1a.

Figure 1b is a perspective view of a second embodiment of the actuation element 1 according to the invention, wherein in this Figure a resilient element 47 in the form of an annular spring 49 is received in the resilient element receiving member 31.

The resilient element 47 defines an effective direction W, in which a straight line G extends. The first positive-locking connection element 7, the second positive-locking connection element 11 and the resilient element 47 are arranged on that straight line G.

The effective direction W is directed in the same direction as a resilient force F_{F}, that is to say, centrally towards the first positive-locking connection element 7 and the second positive-locking connection element 11, so that tilting as a result of a decentralised positive-locking connection element 7, 11 which is contacted with the resilient force F_{F} is prevented.

Figure 1b does not show a cam 3 so that an abutment face 51 of the actuation element 1 can be seen. The abutment face 51 has a catch edge 53, which will be discussed in greater detail in the subsequent Figures.

The embodiment of the actuation element 1 of Figure 1b does not have a display element 33 but, on the other hand, has only smaller differences in the region of the catch walls 29 and the first positive-locking connection element 7 in comparison with the embodiment of the actuation element 1 of Figure 1a. In the second embodiment of the actuation element 1, the first positive-locking connection element 7 comprises two clamping jaws 9a, 9b and the catch walls 29 have openings 53.

The distal end of the actuation element 1 with respect to the resilient element receiving member 31 has a recess 55, in which the drive element 37 is partially received (see Figure 1a) .

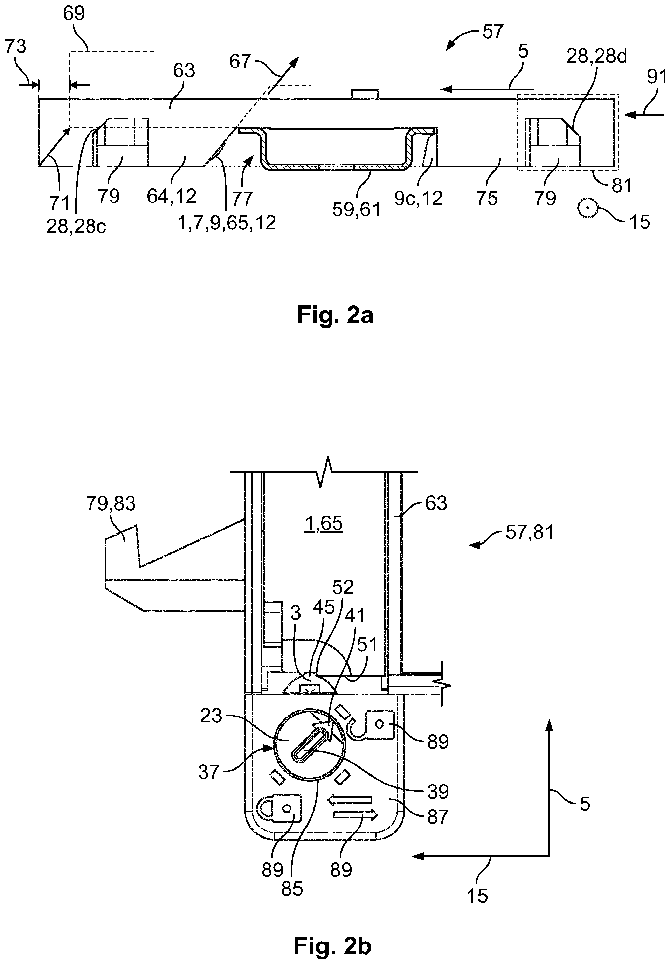

Figure 2a is a side view of the rail fixing system 57 according to the invention. The rail fixing system 57 is positioned on a profile rail 59 which is a top hat rail 61 in the embodiment shown.

The rail fixing system 57 comprises a housing 63 in which the actuation element 1 is received. Of the actuation element 1 which is in the open position 65, only the first positive-locking connection element 7 in the form of a clamping jaw 9 can be partially seen.

In the open position 65 of the actuation element 1, it is possible to move the rail fixing system 57 away from the profile rail 59 in a removal direction 67.

This movement is indicated by a removal position 69 which is indicated with broken lines (see displacement arrow 71 which indicates the displacement of the rail fixing system 57 in the removal direction 67).

There is also shown an insertion distance 73 by which the rail fixing system has to be displaced in relation to an insertion position 75 counter to the longitudinal direction 5 in order to ensure correct positioning of the rail fixing system 57 on the profile rail 59.

The profile rail 59 is received in a rail receiving member 77 which is indicated by a dotted line. In the embodiment of the rail fixing system 57 shown in Figure 2a, the profile rail 59 is received almost completely in the rail receiving member 77.

Furthermore, Figure 2a shows a rigid clamping jaw 9c, that is to say, a clamping jaw which is non-movable in relation to the housing 63 of the rail fixing system 57, which is located at the opposite end of the rail receiving member 77 with respect to the first positive-locking connection element 7 in relation to the longitudinal direction 5.

The non-movable clamping jaw 9c and the lateral faces 64 (of which only one is visible) are additional components of the rail fixing arrangement 12.

The rail fixing system 75 of Figure 2a also has two counter-elements 79 which are illustrated as a different view, for example, in Figure 2b.

The counter-elements 79 each have a contour 28, wherein the third contour 28c complements the second contour 28b shown in Figure 1b. However, the fourth contour 28d does not complement the first contour 28a shown in Figure 1b.
Figure 2b is a plan view of the detail region 81 of the rail fixing system 57. In order to illustrate the position, as in Figure 2a, both the longitudinal direction 5 and the transverse direction 15 are indicated.

The detail region 81 shows the housing 63, the counter-element 79 which is in the form of a catch hook 83 (the second catch hook 83 is not shown in the detail region 81) and the drive element 37.

The catch hook 83 is also a component of the system coupling arrangement 14.

Of the drive element 37, only an upper side 23 can be seen, as well as the groove-like receiving member 39 and the indicator element 41. The drive element 37 is received in a circular receiving member 85 which is located in a covering element 87.

The covering element 87 can be constructed as a monolithic portion of the housing 63. The view of Figure 2b shows the cam 3 which touches the abutment face 51 in the region of the catch edge 52 by means of one of the three catch projections 45 thereof and engages the actuation element 1 in the open position 65.

The indicator element 41 is directed with the tip thereof towards one of three pictograms 89 which provide the user with simple information relating to the position of the actuation element 1.

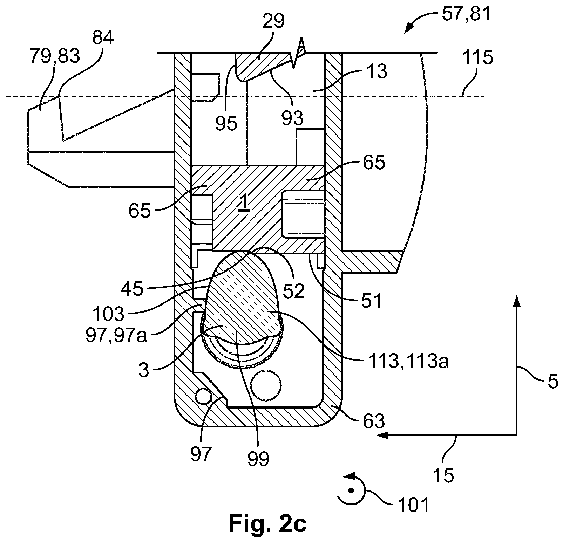

Figure 2c is a section of the detail region 81 illustrated in Figure 2b, wherein the section along a plane which is defined by the longitudinal direction 5 and the transverse direction 15 is brought about at a height 91 illustrated in Figure 2a.

The section illustrated in Figure 2c is brought about under the upper side 23 of the actuation element 1 at the height of the cam 3. The section of Figure 2c shows the catch opening 13 and a catch wall 29 and discloses that the catch wall 29 has an inclined introduction member 93 which is directed away from the catch hook 83 and a catch face 95 which is directed towards the catch hook 83, wherein the catch face 95 is orientated substantially at a small angle relative to the longitudinal direction 5 but the inclined introduction member 93 is orientated at an angle greater than 60° up to an angle practically perpendicular to the longitudinal direction 5.

Figure 2c shows the sectioned cam 3, the mechanical contact of one of the 3 catch projections 45 of the cam 3 with the catch edge 52 of the abutment face 51 and two stop elements 97 which are constructed at the inner side of the housing 63.

The first stop element 97a prevents additional rotation of the cam 3 about the centre point 99 in a counter-clockwise rotational direction 101, by an outer face 103 of the cam 3 abutting against the first stop element 97a and preventing additional rotation in the rotational direction 101.

A rotational position 113 of the cam 3 corresponds to a first rotational position 113a, wherein this first rotational position 113a results in the open position 65 of the actuation element 1.

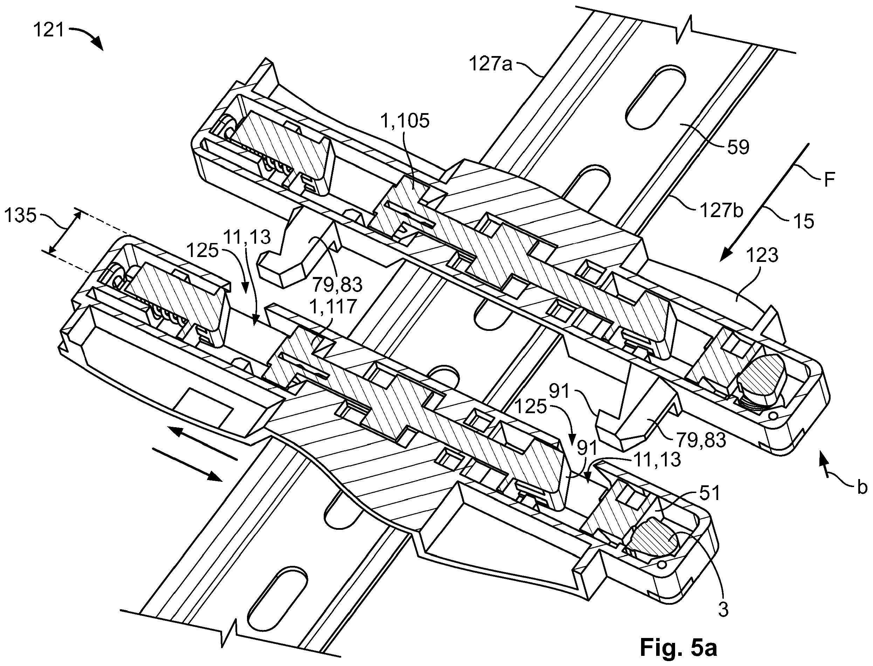

There is indicated for Figures 5a-5c which are intended to be described below an auxiliary line 115 which extends parallel with the transverse direction 15 through the tip 84 of the catch hook 83. That auxiliary line 115 extends through the catch opening 13 and does not intersect with the catch wall 29.

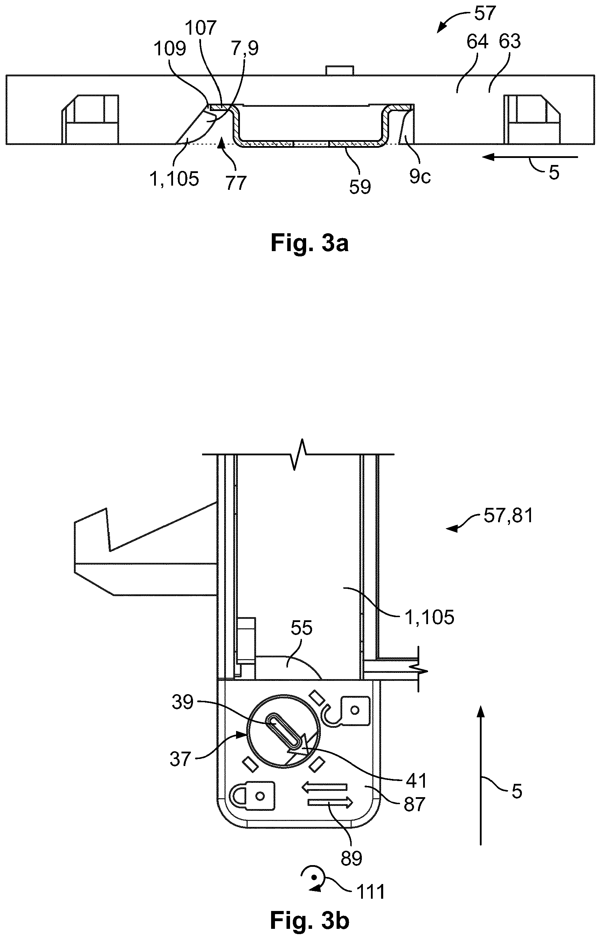

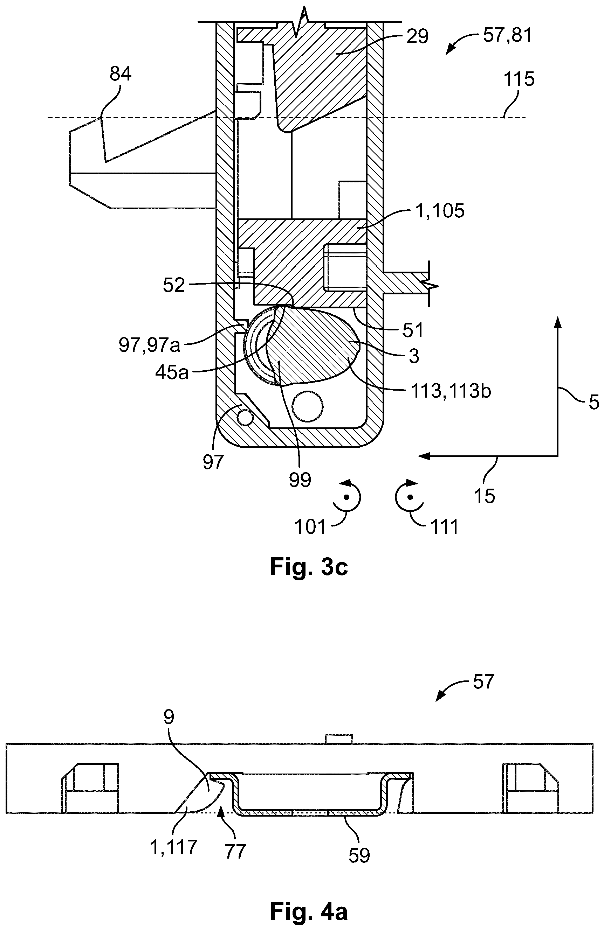

Figures 3a, 3b and 3c show the same elements and views as Figures 2a, 2b and 2c. The differences are discussed below.

The actuation element 1 of the rail fixing system 57 shown in Figure 3a is shown in the displacement position 105 in which the first positive-locking connection element 7 which is constructed as a clamping jaw 9 projects further into the rail receiving member 77 than is the case in the open position 65 which is shown in Figure 2a. By the clamping jaw 9 moving into the rail receiving member 77, the size of the rail receiving member 77 decreases which is illustrated by a dotted line.

In the displacement position 105 of the actuation element 1, the rail fixing system 57 is connected to the profile rail 59 in a non-releasable manner. There remains between the clamping jaw 9 and a first rail side 107 a play 109 which allows displacement of the rail fixing system 57 in or counter to the transverse direction 15; in the case of any other movement of the rail fixing system, it abuts against the profile rail 59 with the lateral face 64 of the housing 63, with the clamping jaw 9 or with the non-movable clamping jaw 9c, and prevents additional movement of the rail fixing system 57.

Figure 3b shows that the drive element 37 has been rotated in a clockwise rotational direction 111. This may have been carried out inter alia by inserting the tip of a screwdriver (not shown) into the groove-like receiving members 39 and subsequent rotation of the drive element 37 by means of the screwdriver.

The rotation of the drive element 37 was carried out at an angle of substantially 90°, wherein the precise rotation is dependent on the embodiment of the cam 3 (cannot be seen in Figure 3b) and the number of engagement positions of the actuation element 1.

The indicator element 41 is now directed towards a second pictogram 89 which indicates the position of the actuation element 1 in the displacement position 105.

In that the actuation element 1 has been displaced counter to the longitudinal direction 5, the support face 51 in Figure 3b is covered by the covering element 87 and only the recess 55 can be identified.

Figure 3c discloses that the cam 3 which is rotated through 90° in the clockwise direction is responsible for the actuation element 1 being moved counter to the longitudinal direction 5. What is decisive for this movement is a resilient element 47 which is shown, for example, in Figure 1b. This resilient element 47 applies the resilient force F_{F} to the actuation element 1 counter to the longitudinal direction 5.

Figure 3c further shows that the catch edge 52 of the stop face 51 now forms with a lateral catch projection 45a a positive-locking engagement so that only an action of force of the actuation element 1 counter to the longitudinal direction 5 does not bring about a rotation of the cam 3. The rotational position 113 of the cam 3 in Figure 3c corresponds to a second rotational position 113b, wherein this second rotational position 113b results in the displacement position 105 of the actuation element 1.

Figure 3c further shows that none of the stop elements 97, 97a is in contact with the cam 3 so that the cam 3 can be rotated about the centre point 99 both in a counter-clockwise rotational direction 101 and in a clockwise rotational direction 111.

The auxiliary line 115 is also indicated in Figure 3c, wherein the auxiliary line 115 intersects with the catch wall 29 in the displacement position 105 of the actuation element 1. This condition is involved again in Figures 5a-5c when a plurality of rail fixing systems 57 according to the invention are operatively connected to each other.

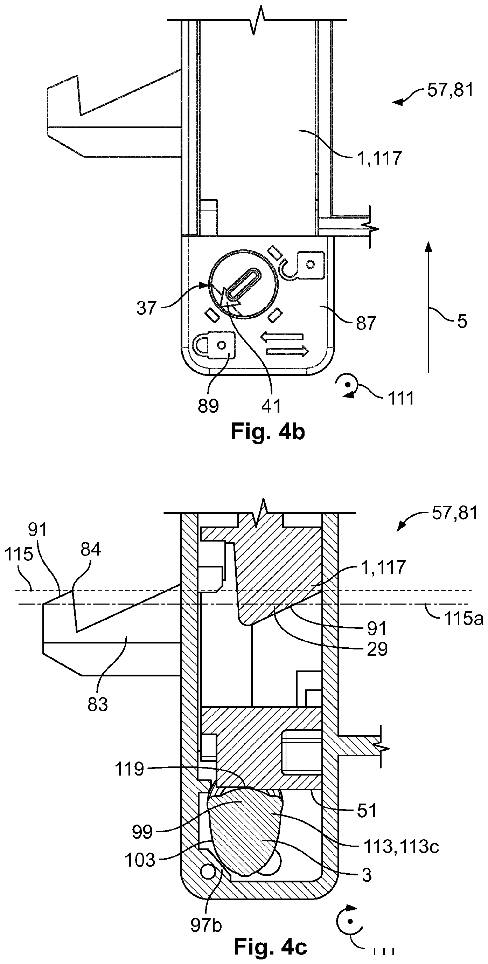

Figures 4a, 4b and 4c also show the same objects or views as Figures 2a, 2b and 2c.

Figure 4a shows the actuation element 1 in the closed position 117, which is characterised in that the clamping jaw 9 is received in the rail receiving member 77 to a greater extent than in the displacement position 105 shown in Figure 3a.

The clamping jaw 9 substantially brings about a positive-locking connection of the rail receiving member 77 with portions of the profile rail 59 so that no play 109 (not shown) remains between the rail fixing system 57 and the profile rail 59. The clamping jaw 9 is pressed into the rail receiving member 77 by means of the resilient element 47 (not visible) and against the profile rail 59.

Figure 4b shows that the drive element 37 is rotated by an additional 90° in a clockwise rotational direction 111 in comparison with Figure 3b. The indicator element 41 is directed in this Figure towards the third pictogram 89 and indicates that the actuation element 1 is in the closed position 117.

Since the actuation element 1 in the closed position 117 is displaced further counter to the longitudinal direction 5 in comparison with the displacement position 105, the recess 55 is now also covered by the covering element 87.

In the cross-section of Figure 4c, the cam 3 is shown in a rotational position 113 which corresponds to a third rotational position 113c, wherein this third rotational position 113c results in the closed position 117 of the actuation element 1.

In this rotational position 113c, the outer face 103 of the cam 3 touches a second stop element 97b so that an additional rotation movement of the cam 3 about the centre point 99 in the clockwise rotational direction 111 is prevented.

The actuation element 1 abuts in the closed position 117 against a near point 119 of the outer face 103 of the cam 3 with the abutment face 51 thereof. The near point 119 is characterised in that it is nearest the centre point 99 of the cam 3 of all the points located on the outer face 103.

The auxiliary line 115 is also shown in Figure 4c, wherein it clearly intersects with the catch wall 29 in Figure 4c.

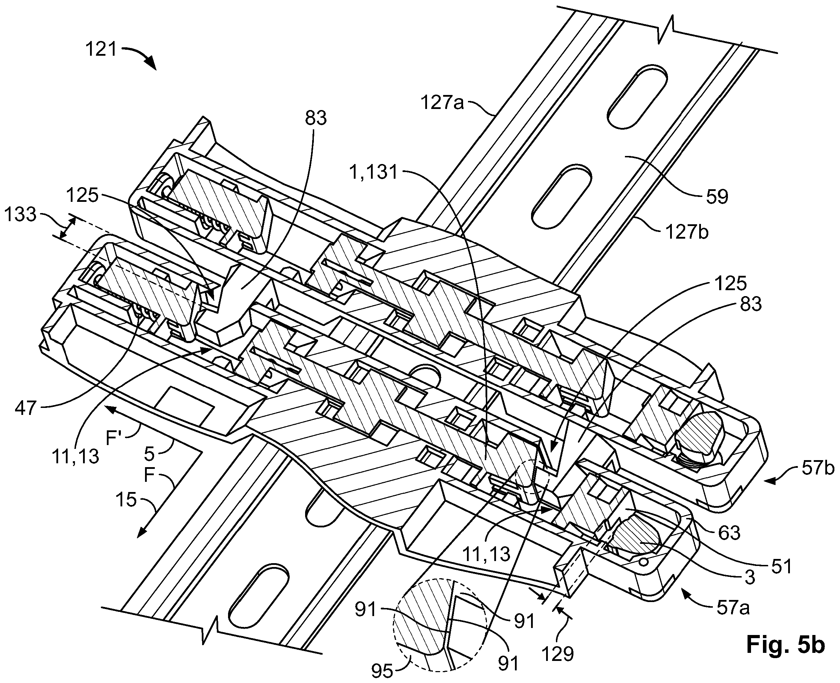

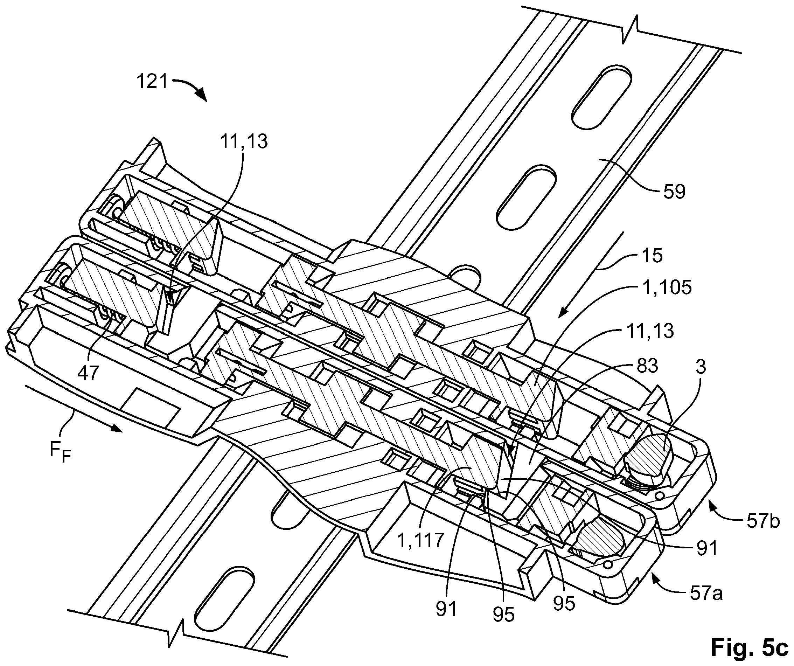

The engagement of two identical rail fixing systems 57 which constitute a set 121 of rail fixing systems with each other and with respect to the profile rail 59 is set out below with reference to Figures 5a, 5b and 5c.

Figures 5a-5c each show two substantially identical rail fixing systems 57 as a perspective sectional view. Both rail fixing systems 57 are part of a device (not shown) which is indicated by the cutaway housing portion 123 of the respective rail fixing system 57.

For the purpose of differentiation, the rail fixing system 57 which is positioned on the profile rail 59 further in the transverse direction 15 is referred to as the first rail fixing system 57a and the rail fixing system 57 which is positioned on the profile rail 59 to a lesser extent in the transverse direction 15 is referred to as the second rail fixing system 57b.

The actuation element 1 of the first rail fixing system 57a is in the closed position 117 whereas the actuation element 1 of the second rail fixing system 57b is in the displacement position 105.

Consequently, the first rail fixing system 57a is securely connected to the profile rail 59, whereas the second rail fixing system 57b is movable along or counter to the transverse direction 15 on the profile rail 59.

The first rail fixing system has housing openings 125 which are directed counter to the transverse direction 15. The counter-elements 79 of the second rail fixing system 57b in the form of catch hooks 83 are directed in the transverse direction 15. In the transverse direction 15, the housing openings 125 each afford access to the second positive-locking connection element 11 which is in the form of a catch opening 13. As a result of the size and/or form and/or extent direction and/or number of the catch openings 13 and catch hooks 83, it is possible to encode a desired variant of the rail fixing system 57.

Both the housing openings 125 and the catch hooks 83 are arranged at both sides of the profile rail 59, wherein the housing opening 125 which is arranged at one side of the profile rail 59 is located with the same spacing from the profile rail 59 as the catch hook 83 which is arranged at the same side.

In order to engage both rail fixing systems 57a, 57b, the second rail fixing system 57b is moved in a transverse direction 15 towards the first rail fixing system 57a.

In Figure 5b, both rail fixing systems 57a, 57b are moved towards each other until they are so close that the catch hook 83 of the second rail fixing system 57b projects through the housing openings 125 of the first rail fixing system 57a into the interior of the housing 63 and into the catch openings 13.

The first mechanical contact between the catch hook 83 of the second rail fixing system 57b and the actuation element 1 of the first rail fixing system is brought about between the inclined introduction member 93 of the actuation element 1 and the inclined introduction member 91 of the catch hook 83.

At this point, reference may be made to Figure 4c, in which the location is indicated by means of the auxiliary line 115 and the additional auxiliary line 115a, where the inclined introduction member 91 of the catch wall 29 and the inclined introduction member 91 of the catch hook 83 touch each other. However, this assessment can be carried out only when structurally identical rail fixing systems 57 are connected to each other.

As a result of both inclined introduction members 91 striking each other, that is to say, the member of the catch hook 83 of the second rail fixing system 57b and the member of the actuation element 1 of the first rail fixing system 57a, the actuation element 1 of the first rail fixing system 57a is redirected in the actuation direction 6 because the inclined introduction members 91 redirect in the actuation direction 6 the force F which is applied during the movement of the second rail fixing system 57b in the transverse direction 15.

The force F' redirected by means of the inclined introduction members 91 acts in an actuation direction 6 counter to the resilient element 47 so that it is compressed.

In Figure 5a, the covered first positive-locking connection element 7 abuts against the rear edge 127a of the profile rails 59 while the non-movable clamping jaw 9c (which also cannot be seen) abuts against the front edge 127b of the profile rail 59.

In the closed position 117 of the actuation element 1 of the first rail fixing system 57a, consequently, the resilient force F_{F} which is transmitted by the resilient element 47 counter to the actuation direction 6 to the actuation element 1 which is located in the closed position 117 acts on the covered first positive-locking connection element 7 but not on the cam 3.

For this reason, a play 109 can be seen in Figure 5a between the cam 3 and the abutment face 51 of the actuation element 1 of the first rail fixing system 57a.

In Figure 5b, the actuation element 1 of the first rail fixing system 57a has been redirected in the actuation direction 6 so that a spacing 129 is formed between the cam 3 and the actuation face 51.

The actuation element 1 of the first rail fixing system 47a is located in an intermediate position 131 which is dependent on an insertion depth 133 of the catch hook 83 and which cannot be engaged.

Figure 5c shows the set of rail fixing systems 121 with a completed system coupling, that is to say, the catch hooks 83 of the second rail fixing system 57b are brought into positive-locking engagement with the respective catch openings 13 of the actuation element 1 of the first rail fixing system 57a.

The arrangement of both rail fixing systems 57a, 57b as shown in Figure 5c is achieved as soon as the insertion depth 133 reaches or exceeds the actuation spacing 135 indicated in Figure 5a as a result of the displacement of the second rail fixing system 57b on the profile rail 59 in a transverse direction 15.

If this is the case, the two inclined insertion members 91 of the catch hook 83 and the actuation element 1 of the first rail fixing system 57a are no longer in mechanical contact with each other and the resilient force F_{F} of the resilient element 47 moves the actuation element 1 of the first rail fixing system 57a back into the closed position 117.

In this state, the catch hooks 83 are completely received in the catch openings 13.

With the active housing coupling shown in Figure 5c between the two rail fixing systems 57a, 57b, it is no longer possible to separate the two rail fixing systems from each other without actuating the actuation element 1 of the first rail fixing system 57a. The catch face 95 of the catch wall 29 abuts against the catch face 95 of the catch hook 83 and consequently prevents a movement of the two rail fixing systems 57a, 57b apart from each other.

The actuation element of the second rail fixing system 57b is further located in Figure 5c in the displacement position 105 and, in another step which is not shown, can also be moved into the closed position 117 by means of the cam 3.

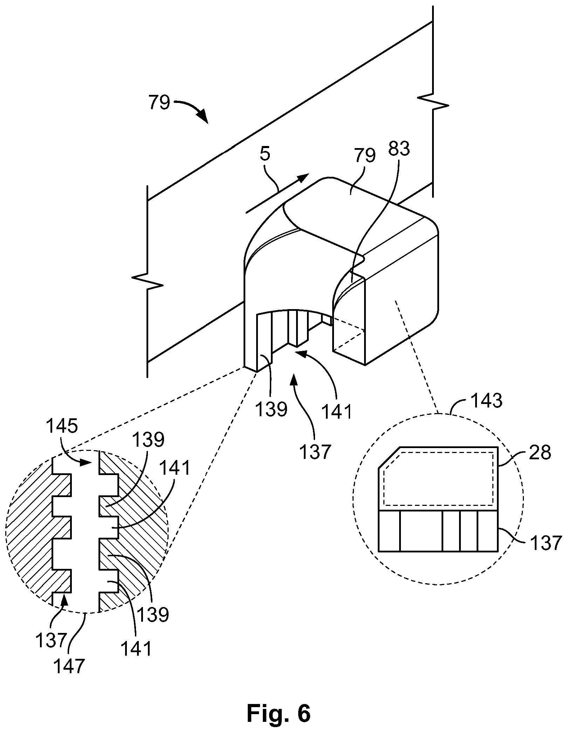

Figure 6 is a perspective detailed view of a counter-element 79. The counter-element 79 has the catch hook 83 and further has a coupling control counter-contour 137. The coupling control counter-contour 137 comprises projections 139 and recesses 141. The projections 139 and recesses 141 are arranged with different spacings from each other in the longitudinal direction 5. A first cutout 143 shows the side view of the counter-element 79 and in particular the contour 28 and coupling control counter-contour 137 thereof.

The contour 28 is in the form of a parallelogram and is illustrated by a broken line.

The coupling control counter-contour 137 is constructed so as to be brought into engagement with a complementary coupling control contour 145. That coupling control contour 145 is schematically illustrated as a cross-section in the second cutout 147.

The coupling control contour 145 also has projections 139 and recesses 141 in different forms and/or numbers.

### Reference numerals

- 1: Actuation device
- 3: Cam
- 5: Longitudinal direction
- 6: Actuation direction
- 7: First positive-locking connection element
- 9, 9a, 9b: Clamping jaw
- 9c: Non-movable clamping jaw
- 11: Second positive-locking connection element
- 12: Rail fixing arrangement
- 13: Catch opening
- 13a: Positive-locking connection opening
- 14: System coupling arrangement
- 15: Transverse direction
- 16: Passage direction
- 17: Central region
- 19: Support element
- 21: Wing-like strut
- 23: Upper side
- 25: Shaft
- 27: Shaft wall
- 27a: Wall
- 28(a/b/c/d): (First/second/third/fourth) contour
- 29: Catch wall
- 31: Resilient element receiving member
- 33: Display element
- 35: Axle
- 37: Drive element
- 39: Groove-like receiving member
- 41: Indicator element
- 43: Catch element
- 45: Catch projection
- 45a: Lateral catch projection
- 47: Resilient element
- 49: Annular spring
- 51: Abutment face
- 52: Catch edge
- 53: Opening
- 55: Recess
- 57: Rail fixing system
- 57a: First rail fixing system
- 57b: Second rail fixing system
- 59: Profile rail
- 61: Top hat rail
- 63: Housing
- 64: Lateral face
- 65: Open position
- 67: Removal direction
- 69: Removal position
- 71: Displacement arrow
- 73: Insertion distance
- 75: Insertion position
- 77: Rail receiving member
- 79: Counter-element
- 81: Detail region
- 83: Catch hook
- 85: Circular receiving member
- 87: Covering element
- 89: Pictogram
- 91: Height
- 93: Inclined introduction member
- 95: Catch face
- 97: Stop element
- 97a: First stop element
- 97b: Second stop element
- 99: Centre point
- 101: Counter-clockwise rotational direction
- 103: Outer face
- 105: Displacement position
- 107: First rail side
- 109: Play
- 111: Clockwise rotational direction
- 113: Rotational position
- 113a: First rotational position
- 113b: Second rotational position
- 113c: Third rotational position
- 115: Auxiliary line
- 115a: Additional auxiliary line
- 117: Closed position
- 119: Near point
- 121: Set of rail fixing systems
- 123: Cutaway housing portion
- 125: Housing opening
- 127a: Rear edge
- 127b: Front edge
- 129: Spacing
- 131: Intermediate position
- 133: Insertion depth
- 135: Actuation spacing
- 137: Coupling control counter-contour
- 139: Projection
- 141: Recess
- 143: First cutout
- 145: Coupling control contour
- 147: Second cutout
- F: Force
- F': Redirected force
- F_{F}: Resilient force
- G: Straight line
- W: Effective direction

## Claims

1. A rail fixing system (57) for devices which can be fixed to a profile rail (59), in particular a top hat rail (61), having a rail fixing arrangement (12) for fixing the rail fixing system (57) to the profile rail (59), wherein the rail fixing arrangement (12) has a first movable positive-locking connection element (7), having a system coupling arrangement (14) for fixing to each other rail fixing systems (57, 57a, 57b) which are arranged on the profile rail (59) beside each other, wherein the system coupling arrangement has a second movable positive-locking connection element (11) and wherein the rail fixing arrangement (12) and the system coupling arrangement (14) have a common movable actuation device (1) which is connected to the first positive-locking connection element (7) and second positive-locking connection element (11) so as to transmit movement, wherein the actuation device (1) is supported on at least one resilient element (47), wherein the first positive-locking connection element (7), the second positive-locking connection element (11) and the resilient element (47) are arranged along a straight line (G) which extends in the effective direction (W) of the resilient element (47),
**characterised in that** the actuation device (1) has at least one rotatable cam (3) and **in that** a position of the first positive-locking connection element (7) and second positive-locking connection element (11) is dependent on a rotational position (113, 113a, 113b, 113c) of the at least one cam (3).

2. The rail fixing system (57) according to claim 1,
**characterised in that** the rail fixing system (57) has a channel-like rail receiving member (77) which is continuous in a passage direction (16) for the profile rail (59), **in that** the actuation device (1) can be displaced transversely relative to the passage direction (16) and **in that** the straight line (G) which extends in the effective direction (W) of the resilient element (47) extends through the channel-like rail receiving member (77).

3. The rail fixing system (57) according to claim 1 or claim 2,
**characterised in that** the actuation device (1) is constructed between an open position (65) and a closed position (117) so as to be able to be engaged in a displacement position (105) for displacement of the rail fixing system (57) along the profile rail (59).

4. The rail fixing system (57) according to claim 3,
**characterised in that** the first positive-locking connection element (7) in the displacement position (105) projects in or counter to the effective direction (W) of the resilient element (47) into the rail receiving member (77) to a lesser extent than in the closed position (117).

5. The rail fixing system (57) according to any one of claims 1 to 4, **characterised in that** the actuation device (1) is substantially completely received inside the rail fixing system (57) .

6. The rail fixing system (57) according to any one of claims 1 to 5, **characterised in that** the second positive-locking connection element (11) is constructed as a positive-locking connection opening (13a) which opens substantially perpendicularly to the straight line (G) and which is completely surrounded by a closed peripheral wall (27a).

7. The rail fixing system (57) according to claim 6,
**characterised in that** the positive-locking connection opening (13a) is encoded by a contour of the wall (27a).

8. The rail fixing system (57) according to claim 7,
**characterised in that** a counter-element (79) which is encoded so as to complement the second positive-locking connection element (11) is located at one of the two lateral faces (64) of the rail fixing system housing (63), opposite the second positive-locking element (11) in a passage direction (16) for the profile rail (59).

9. The rail fixing system (57) according to claims 8,
**characterised in that** a coupling control contour (145) which has at least one protrusion(s) (3) or recess(es) (141) which extend(s) in the passage direction (16) is constructed at one of the two lateral faces (64) which are opposite each other in the passage direction (16) and **in that** the coupling control contour (145) is adapted to prevent the coupling of different rail fixing systems (57).

10. The rail fixing system (57) according to any one of claims 2 to 9, **characterised in that** the actuation device (1) is supported at the centre thereof in a direction perpendicular to the passage direction (16).

11. The rail fixing system (57) according to any one of claims 1 to 10, **characterised in that** there is provided a display element (33) which is connected to the actuation device (1) and which is movable therewith for displaying the position (65, 105, 117) of the actuation device (1) in a manner visible from outside the rail fixing system (57).

12. The rail fixing system (57) according to claim 11,
**characterised in that** the display element (33) is constructed monolithically with the actuation device (1).

13. The rail fixing system (57) according to any one of claims 1 to 12, **characterised in that** the first positive-locking connection element (7) is located at the side of the channel-like rail receiving member (77) opposite the cam (3).

14. A set (121) comprising at least two rail fixing systems (57) for devices which can be fixed to a profile rail (59), in particular a top hat rail (61), **characterised in that** at least one, preferably each, of the at least two rail fixing systems (57) is a rail fixing system (57) according to the invention according to any one of claims 1 to 13.

## Patentansprüche

1. Schienenbefestigungs-System (57) für Einrichtungen, die an einer Profilschiene (59), insbesondere einer Hutschiene (61), befestigt werden können, die eine Schienenbefestigungs-Anordnung (12) zum Befestigen des Schienenbefestigungs-Systems (57) an der Profilschiene (59) aufweist, wobei die Schienenbefestigungs-Anordnung (12) ein erstes bewegliches formschlüssiges Verbindungselement (7) mit einer Systemkopplungs-Anordnung (14) aufweist, mit der Schienenbefestigungs-Systeme (57, 57a, 57b) aneinander befestigt werden, die an der Profilschiene (59) nebeneinander angeordnet sind, wobei die Systemkopplungs-Anordnung ein zweites bewegliches formschlüssiges Verbindungselement (11) aufweist und die Schienenbefestigungs-Anordnung (12) und die Systemkopplungs-Anordnung (14) eine gemeinsame bewegliche Betätigungseinrichtung (1) aufweisen, die mit dem ersten formschlüssigen Verbindungselement (7) und dem zweiten formschlüssigen Verbindungselement (11) so verbunden ist, dass Bewegung übertragen wird, wobei die Betätigungseinrichtung (1) an wenigstens einem elastischen Element (47) gelagert ist, das erste formschlüssige Verbindungselement (7), das zweite formschlüssige Verbindungselement (11) und das elastische Element (47) entlang einer Geraden (G) angeordnet sind, die in der Wirkrichtung (W) des elastischen Elementes (47) verläuft, **dadurch gekennzeichnet, dass** die Betätigungseinrichtung (1) wenigstens einen drehbaren Nocken (3) aufweist und dadurch, dass eine Position des ersten formschlüssigen Verbindungselementes (7) und des zweiten formschlüssigen Verbindungselementes (11) von einer Drehposition (113, 113a, 113b, 113c) des wenigstens einen Nockens (3) abhängt.

2. Schienenbefestigungs-System (57) nach Anspruch 1, **dadurch gekennzeichnet, dass** das Schienenbefestigungs-System (57) ein kanalartiges Schienenaufnahme-Element (77) aufweist, das sich durchgehend in einer Durchgangsrichtung (16) für die Profilschiene (59) erstreckt, dadurch, dass die Betätigungseinrichtung (1) quer zu der Durchgangsrichtung (16) verschoben werden kann, und dadurch, dass die Gerade (G), die in der Wirkrichtung (W) des elastischen Elementes (47) verläuft, durch das kanalartige Schienenaufnahme-Element (77) hindurch verläuft.

3. Schienenbefestigungs-System (57) nach Anspruch 1 oder Anspruch 2, **dadurch gekennzeichnet, dass** die Betätigungseinrichtung (1) konstruktiv zwischen einer offenen Stellung (65) und einer geschlossenen Stellung (117) so ausgebildet ist, dass sie in eine Verschiebestellung (105) für Verschiebung des Schienenbefestigungs-Systems (57) entlang der Profilschiene (59) gebracht werden kann.

4. Schienenbefestigungs-System (57) nach Anspruch 3, **dadurch gekennzeichnet, dass** das erste formschlüssige Verbindungselement (7) in der Verschiebestellung (105) in oder entgegen der Wirkrichtung (W) des elastischen Elementes (47) weniger weit in das Schienenaufnahme-Element (77) hinein vorsteht als in der geschlossenen Stellung (117).

5. Schienenbefestigungs-System (57) nach einem der Ansprüche 1 bis 4, **dadurch gekennzeichnet, dass** die Betätigungseinrichtung (1) im Wesentlichen vollständig im Inneren des Schienenbefestigungs-Systems (57) aufgenommen ist.

6. Schienenbefestigungs-System (57) nach einem der Ansprüche 1 bis 5, **dadurch gekennzeichnet, dass** das zweite formschlüssige Verbindungselement (11) konstruktiv als eine formschlüssige Verbindungsöffnung (13a) ausgebildet ist, die sich im Wesentlichen senkrecht zu der Geraden (G) öffnet und die vollständig von einer geschlossenen Umfangswand (27a) umgeben ist.

7. Schienenbefestigungs-System (57) nach Anspruch 6, **dadurch gekennzeichnet, dass** die formschlüssige Verbindungsöffnung (13a) durch eine Kontur der Wand (27a) kodiert ist.

8. Schienenbefestigungs-System (57) nach Anspruch 7, **dadurch gekennzeichnet, dass** ein Gegenelement (79), das so kodiert ist, dass es komplementär zu dem zweiten formschlüssigen Verbindungselement (11) ist, an einer der zwei Seitenflächen (64) des Gehäuses (63) des Schienenbefestigungs-Systems dem zweiten formschlüssigen Verbindungselement (11) in einer Durchgangsrichtung (16) für die Profilschiene (59) gegenüberliegend angeordnet ist.

9. Schienenbefestigungs-System (57) nach Anspruch 8, **dadurch gekennzeichnet, dass** eine Kopplungssteuerungs-Kontur (145), die wenigstens einen oder mehrere Vorsprung/Vorsprünge (3) oder eine oder mehrere Aussparung/en (141) aufweist, der/die sich in der Durchgangsrichtung (16) erstreckt/erstrecken, konstruktiv an einer der zwei Seitenflächen (64) ausgebildet ist, die einander in der Durchgangsrichtung (16) gegenüberliegen, und dadurch, dass die Kopplungssteuerungs-Kontur (145) so eingerichtet ist, dass sie das Koppeln unterschiedlicher Schienenbefestigungs-Systeme (57) verhindert.

10. Schienenbefestigungs-System (57) nach einem der Ansprüche 2 bis 9, **dadurch gekennzeichnet, dass** die Betätigungseinrichtung (1) in ihrer Mitte in einer Richtung senkrecht zu der Durchgangsrichtung (16) gelagert ist.

11. Schienenbefestigungs-System (57) nach einem der Ansprüche 1 bis 10, **dadurch gekennzeichnet, dass** ein Anzeigeelement (33) vorhanden ist, das mit der Betätigungseinrichtung (1) verbunden ist und mit ihr bewegt werden kann, um die Position (65, 105, 117) der Betätigungseinrichtung (1) so anzuzeigen, dass sie von außerhalb des Schienenbefestigungs-Systems (57) sichtbar ist.

12. Schienenbefestigungs-System (57) nach Anspruch 11, **dadurch gekennzeichnet, dass** das Anzeigeelement (33) konstruktiv monolithisch mit der Betätigungseinrichtung (1) ausgebildet ist.

13. Schienenbefestigungs-System (57) nach einem der Ansprüche 1 bis 12, **dadurch gekennzeichnet, dass** sich das erste formschlüssige Verbindungselement (7) an der Seite des rinnenförmigen Schienenaufnahme-Elementes (77) befindet, die dem Nocken (3) gegenüberliegt.

14. Satz (121), der wenigstens zwei Schienenbefestigungs-Systeme (57) für Einrichtungen umfasst, die an einer Profilschiene (59), insbesondere einer Hutschiene (61), befestigt werden können, **dadurch gekennzeichnet, dass** wenigstens eines, vorzugsweise jedes, der wenigstens zwei Schienenbefestigungs-Systeme (57) ein erfindungsgemäßes Schienenbefestigungs-System (57) nach einem der Ansprüche 1 bis 13 ist.

## Revendications

1. Système de fixation de rail (57) pour des dispositifs qui peuvent être fixés à un rail profilé (59), en particulier un rail oméga (61), ayant un agencement de fixation de rail (12) pour fixer le système de fixation de rail (57) au rail profilé (59), dans lequel l'agencement de fixation de rail (12) a un premier élément de liaison par verrouillage positif mobile (7), ayant un agencement d'accouplement de système (14) pour fixer entre eux des systèmes de fixation de rail (57, 57a, 57b) qui sont agencés sur le rail profilé (59) les uns à côté des autres, dans lequel l'agencement d'accouplement de système a un deuxième élément de liaison par verrouillage positif mobile (11) et dans lequel l'agencement de fixation de rail (12) et l'agencement d'accouplement de système (14) ont un dispositif d'actionnement mobile commun (1) qui est relié au premier élément de liaison par verrouillage positif (7) et au deuxième élément de liaison par verrouillage positif (11) de manière à transmettre un mouvement, dans lequel le dispositif d'actionnement (1) est supporté sur au moins un élément élastique (47), dans lequel le premier élément de liaison par verrouillage positif (7), le deuxième élément de liaison par verrouillage positif (11) et l'élément élastique (47) sont agencés le long d'une ligne droite (G) qui s'étend dans la direction efficace (W) de l'élément élastique (47), **caractérisé en ce que** le dispositif d'actionnement (1) a au moins une came rotative (3) et **en ce qu'**une position du premier élément de liaison par verrouillage positif (7) et du deuxième élément de liaison par verrouillage positif (11) dépend d'une position de rotation (113, 113a, 113b, 113c) de l'au moins une came (3).

2. Système de fixation de rail (57) selon la revendication 1, **caractérisé en ce que** le système de fixation de rail (57) a un organe de réception de rail en forme de canal (77) qui est continu dans une direction de passage (16) pour le rail profilé (59), **en ce que** le dispositif d'actionnement (1) peut être déplacé transversalement par rapport à la direction de passage (16) et **en ce que** la ligne droite (G) qui s'étend dans la direction efficace (W) de l'élément élastique (47) s'étend à travers l'organe de réception de rail en forme de canal (77).

3. Système de fixation de rail (57) selon la revendication 1 ou la revendication 2, **caractérisé en ce que** le dispositif d'actionnement (1) est construit entre une position ouverte (65) et une position fermée (117) de manière à pouvoir être engagé dans une position de déplacement (105) pour le déplacement du système de fixation de rail (57) le long du rail profilé (59).

4. Système de fixation de rail (57) selon la revendication 3, **caractérisé en ce que** le premier élément de liaison par verrouillage positif (7) en position de déplacement (105) fait moins saillie dans ou à l'encontre de la direction efficace (W) de l'élément élastique (47) dans l'organe de réception de rail (77) qu'en position fermée (117).

5. Système de fixation de rail (57) selon l'une quelconque des revendications 1 à 4, **caractérisé en ce que** le dispositif d'actionnement (1) est sensiblement complètement reçu à l'intérieur du système de fixation de rail (57).

6. Système de fixation de rail (57) selon l'une quelconque des revendications 1 à 5, **caractérisé en ce que** le deuxième élément de liaison par verrouillage positif (11) est construit sous la forme d'une ouverture de liaison par verrouillage positif (13a) qui s'ouvre sensiblement perpendiculairement à la ligne droite (G) et qui est complètement entourée par une paroi périphérique fermée (27a).

7. Système de fixation de rail (57) selon la revendication 6, **caractérisé en ce que** l'ouverture de liaison par verrouillage positif (13a) est codée par un contour de la paroi (27a).

8. Système de fixation de rail (57) selon la revendication 7, **caractérisé en ce qu'**un contre-élément (7 9) qui est codé de manière à compléter le deuxième élément de liaison par verrouillage positif (11) est situé au niveau de l'une des deux faces latérales (64) du boîtier de système de fixation de rail (63), à l'opposé du deuxième élément de verrouillage positif (11) dans une direction de passage (16) pour le rail profilé (59).

9. Système de fixation de rail (57) selon la revendication 8, **caractérisé en ce qu'**un contour de commande d'accouplement (145) qui a au moins une(des) saillie(s) (3) ou un(des) évidement(s) (141) qui s'étend(s'étendent) dans la direction de passage (16) est construit au niveau de l'une des deux faces latérales (64) qui sont opposées l'une à l'autre dans la direction de passage (16) et **en ce que** le contour de commande d'accouplement (145) est adapté pour empêcher l'accouplement de différents systèmes de fixation de rail (57).

10. Système de fixation de rail (57) selon l'une quelconque des revendications 2 à 9, **caractérisé en ce que** le dispositif d'actionnement (1) est supporté en son centre dans une direction perpendiculaire à la direction de passage (16).

11. Système de fixation de rail (57) selon l'une quelconque des revendications 1 à 10, **caractérisé en ce qu'**il est prévu un élément d'affichage (33) qui est relié au dispositif d'actionnement (1) et qui est mobile avec celui-ci pour afficher la position (65, 105, 117) du dispositif d'actionnement (1) de manière visible depuis l'extérieur du système de fixation de rail (57).

12. Système de fixation de rail (57) selon la revendication 11, **caractérisé en ce que** l'élément d'affichage (33) est construit de manière monolithique avec le dispositif d'actionnement (1).

13. Système de fixation de rail (57) selon l'une quelconque des revendications 1 à 12, **caractérisé en ce que** le premier élément de liaison par verrouillage positif (7) est situé au niveau du côté de l'organe de réception de rail en forme de canal (77) opposé à la came (3).

14. Ensemble (121) comprenant au moins deux systèmes de fixation de rail (57) pour des dispositifs pouvant être fixés à un rail profilé (59), en particulier un rail oméga (61), **caractérisé en ce qu'**au moins un, de préférence chacun, des au moins deux systèmes de fixation de rail (57) est un système de fixation de rail (57) selon l'invention selon l'une quelconque des revendications 1 à 13.
